# EUROPÄISCHE PATENTSCHRIFT

(11) **EP 1 511 877 B1**
(45) Veröffentlichungstag und Bekanntmachung des Hinweises auf die Patenterteilung: **15.09.2010**
(21) Anmeldenummer: 03752719.9
(22) Anmeldetag: 30.04.2003
(51) Int. Cl.: C23C 14/34, H01J 37/34

(54) **SPUTTERVERFAHREN ZUR HERSTELLUNG VON EIGENSPANNUNGSOPTIMIERTEN BESCHICHTUNGEN**
SPUTTER METHOD FOR THE PRODUCTION OF NATURAL VOLTAGE OPTIMIZED COATINGS
PROCEDE DE PULVERISATION CATHODIQUE POUR PRODUIRE DES REVETEMENTS OPTIMISES VIS-A-VIS DES CONTRAINTES RESIDUELLES

(30) Priorität: 22.05.2002 DE 10222909
(43) Veröffentlichungstag der Anmeldung: 09.03.2005
(73) Patentinhaber: OC Oerlikon Balzers AG, 9496 Balzers (LI)
(72) Erfinder: HAAG, Walter, CH-9472 Grabs (CH)
(74) Vertreter: Bockhorni & Kollegen
(86) Internationale Anmeldenummer: PCT/EP2003/004572
(87) Internationale Veröffentlichungsnummer: WO 2003/097896

(56) Entgegenhaltungen:
- REINIG P ET AL: "Pulsed dc magnetron-sputtering of microcrystalline silicon" PREPARATION AND CHARACTERIZATION, ELSEVIER SEQUOIA, NL, Bd. 403-404, 1. Februar 2002 (2002-02-01), Seiten 86-90, XP004430332 ISSN: 0040-6090
- SELLERS J: "Asymmetric bipolar pulsed DC: the enabling technology for reactive PVD" SURFACE AND COATINGS TECHNOLOGY, ELSEVIER, AMSTERDAM, NL, Bd. 98, Nr. 1-3, 9. September 1996 (1996-09-09), Seiten 1245-1250, XP002241685 ISSN: 0257-8972
- PATENT ABSTRACTS OF JAPAN vol. 1995, no. 04, 31. Mai 1995 (1995-05-31) & JP 07 018431 A (ANELVA CORP), 20. Januar 1995 (1995-01-20)

## Beschreibung

Die vorliegende Erfindung betrifft ein Verfahren für Sputterbeschichtungsprozesse, mit denen insbesondere eigenspannungsoptmierte Beschichtungen hergestellt werden können.

Aus dem Stand der Technik ist es bekannt, auf Substraten Beschichtungen durch Sputterverfahren zu erzeugen, bei denen in einer Vakuumanlage ein Plasma gezündet wird, so dass die im Plasma befindlichen Ionen durch Anlegen einer geeigneten Potentialdifferenz auf das Target, welches das zu beschichtende Material enthält, beschleunigt werden und dieses vom Target abtragen, so dass es sich auf dem zu beschichtenden Substrat ablagern kann. Die hierzu am Target einzustellende Potentialdifferenz kann entweder durch Anlegen einer Gleichspannung oder einer gepulsten Spannung erzeugt werden, wobei für den gepulsten Betrieb Frequenzen bis in den Hochfrequenzbereich (Radio frequency RF) gewählt werden können. Das Target bzw. die Sputterkathode wird hierbei jedoch üblicherweise möglichst immer auf negativem Potential oder bei bipolar gepulstem Betrieb, im positiven Pulsbereich auf lediglich niedrigem positivem Potential gehalten, da ein positiver Puls nachteilig ist, weil er dem Plasma Ladungsträger (Elektronen) entzieht. Dies ist jedoch in bestimmten Fällen in dem oben geschilderten geringen Umfang erforderlich, wenn z. B. beim Sputtern von dielektrischen Materialien sich auf dem Target eine isolierende Schicht bildet, die die kapazitiven Verhältnisse in der Beschichtungsanlage beeinträchtigt. Hier kann es dann erforderlich sein, durch Zulassen eines Überschwingens des Spannungsverlaufs ins positive Potential oder durch das Anlegen einer geringen positiven Spannung eine Entladung des Targets zu bewirken, um dadurch Aufladungserscheinungen an den isolierenden Schichten entgegen zu wirken. Aufgrund der oben geschilderten kontraproduktiven Wirkung des positiven Potentials an der Sputterkathode bzw. dem Target, wird das positive Potential jedoch nach dem Stand der Technik sehr niedrig gehalten oder wenn möglich vermieden.

Zur Erzeugung von möglichst eigenspannungsfreien Beschichtungen ist es im Stand der Technik weiterhin bekannt, das Substrat während der Beschichtung mit einer Bias-Spannung zu beaufschlagen ist, die ebenfalls unipolar bzw. bipolar gepulst sein kann. Durch das Anlegen einer Bias-Spannung an das Substrat wird bewirkt, dass die sich auf dem Substrat aufbauende Beschichtung mit Ionen bzw. beim bipolaren Betrieb mit Ionen und Elektronen bombardiert wird. Durch das Auftreffen der Ionen bzw. Elektronen, die durch die Bias-Spannung auf das Substrat hin beschleunigt werden, wird erreicht, dass die sich beim Abscheiden der Beschichtung möglicherweise aufbauenden Eigenspannungen durch eine gezielte Beeinflussung der Schichtstruktur bzw. des Gefüges vermindert werden. Nachteilig ist hierbei jedoch, dass durch das Beschießen des Substrats mit Ionen bzw. Elektronen das Substrat einer erhöhten Temperaturbelastung ausgesetzt ist. Außerdem wird das Beschichtungsverfahren aufwändiger, da für das Substrat eine Spannungsversorgung benötigt wird. Bei einem gepulsten Betrieb der Bias-Spannung fallen hier zusätzliche Einrichtungen an, wie z. B. Signalgeneratoren, Filter oder Synchronisierungskomponenten bei einem mit der Kathodenspannung synchron gepulsten Betrieb. Darüber hinaus sind Sputterprozesse mit einer Substrat-Bias-Spannung schwieriger zu handhaben, da sich beispielsweise die Bias-Spannung durch thermische Effekte während des Prozesses verändern kann, oder am Substrat auf Grund der Bias-Spannung beispielsweise Überschläge auftreten können.

Es ist deshalb Aufgabe der vorliegenden Erfindung ein Verfahren zur Beschichtung von Substraten mittels Sputterprozessen bereitzustellen, bei denen die oben geschilderten Nachteile verringert bzw. vermieden werden können. Insbesondere soll es auch möglich sein Schichteigenschaften sowie spannungsoptimierte Schichten auf Substraten zu erzeugen, bei denen das Aufbringen einer Bias-Spannung nur unter schwierigen Bedienungen möglich oder gar gänzlich unmöglich ist, wie z. B. bei Substraten in rotierenden Substratkörben oder anderen Carriern. Bezüglich der Spannungsoptimierung der Schichten sollte es möglich sein, die insbesondere nachteiligen Zugeigenspannungen in den Schichten weitgehend zu vermindern oder zu verhindern bzw. Druckeigenspannungen in den Schichten einzustellen. Darüber hinaus soll das Verfahren einfach aufgebaut und einfach, d. h. wirtschaftlich, betreibbar sein.

Diese Aufgabe wird gelöst durch ein Verfahren mit Merkmalen des Patentanspruchs 1. Vorteilhafte Ausgestaltungen der Erfindung sind Gegenstand der abhängigen Ansprüche.

Die besonders einfache Lösung der oben geschilderten Aufgabe besteht im Wesentlichen darin, auf die Substrat-Bias-Spannung, die die oben geschilderten Nachteile mit sich bringt, gänzlich zu verzichten und dafür die nach den bisherigen Kenntnissen im Stand der Technik als nachteilig empfundene Aufbringung eines positiven Spannungspulses am Target so auszubilden, dass damit die Bias-Spannung am Substrat ersetzt werden kann. Bei entsprechender Einstellung eines positiven Potentialpulses am Target wird nämlich erreicht, dass Ionen auf das Substrat beschleunigt werden, beispielsweise positiv geladene Argon-Ionen bei Verwendung von Argon als Edelgas. Damit wird der gleiche Zweck erreicht, wie bei der Anlegung einer Substrat-Bias-Spannung, bei der ebenfalls durch Beschleunigung von Ionen aus dem Plasma auf das Substrat die Schichtstruktur so beeinflusst wird, dass negative Zugeigenspannungen abgebaut werden. Darüber hinaus werden dadurch auch sogenannte Rücksputtereffekte erzielt. Übersteigt die positive Beschleunigungsspannung für die Ionen einen Sputterschwellwert, so können anfänglich, lose gebundene Schichtatome, bei weiterer Erhöhung aus der Schicht rückgesputtert werden, was beim Beschichten von "high aspect ratio Strukturen" notwendig ist, um die Seitenwände zu beschichten.

Gegenüber einer Substrat-Bias-Spannung bewirkt das gepulste Anlegen eines positiven Potentials am Target jedoch nur einen gepulsten Beschuss des Substrats mit Ionen und keinen ununterbrochenen Beschuss mit Ionen bzw. Ionen und Elektronen. Auf diese Weise wird die Temperaturbelastung des Substrats minimiert. Außerdem ist eine gezielte Beeinflussung der Schichtstruktur auch bei Substraten möglich, bei denen das Anlegen einer Bias-Spannung Schwierigkeiten bereitet oder gar unmöglich ist. Weiterhin wird durch das Ersetzen der Bias-Spannung am Substrat durch das Vorsehen von positiven Spannungspulsen am Target auch der Aufwand für die Ausrüstung und für den Betrieb der Beschichtungseinrichtung vermindert, da keine zusätzliche Spannungsversorgung für die Bias-Spannung am Substrat vorgesehen werden muss.

Hierbei ist es vorteilhaft sowohl die negative Signalgrundform für das Spannungssignal an der Sputterkathode bzw. am Target als auch das positive Spannungssignal für das erfindungsgemäße Verfahren durch einen Signalgenerator am Target zu erzeugen. Auf diese Weise kann die Sputterbeschichtungsvorrichtung vereinfacht und der Betrieb weniger aufwändig gestaltet werden.

Um jedoch das gepulste positive Spannungssignal am Target hinsichtlich Frequenz, Signalform, Amplitude usw. möglichst frei einstellen zu können, ist es jedoch bevorzugt, das Spannungssignal an der Sputterkathode bzw. am Target durch die Überlagerung einer negativen Signalgrundform mit einem gepulsten positiven Spannungsignal zu erzeugen.

Bei der Herstellung verschiedener Schichten mit dem erfindungsgemäßen Verfahren hat es sich herausgestellt, dass es besonders vorteilhaft ist, wenn die Amplitude des positiven Spannungspulses im Bereich von 30 bis 2000 V, insbesondere 40 bis 1800V, vorzugsweise 50 bis 1000 V, und/ oder die Pulsdauer des positiven Spannungspulses im Bereich von 1 bis 20 µsec gewählt wird. Außerdem hat sich eine Frequenz von 15 bis 450 KHz bewährt.

Weitere Vorteile, Kennzeichen und Merkmale der vorliegenden Erfindung werden bei der nachfolgenden detaillierten Beschreibung eines Vergleichsbeispiels deutlich. Hierbei zeigen die beigefügten Diagramme in
- Fig. 1: einen typischen Verlauf des Potentials am Target;
- Fig. 2: die Eigenspannungsreduzierung bzw. Erhöhung des spezifischen Widerstands bei Schichten, die mit hochfrequenter Bias-Spannung abgeschieden worden sind; und in
- Fig. 3: die Verringerung bzw. Umkehrung der Eigenspannungen in Schichten, die mit dem erfindungsgemäßen Verfahren abgeschieden worden sind.

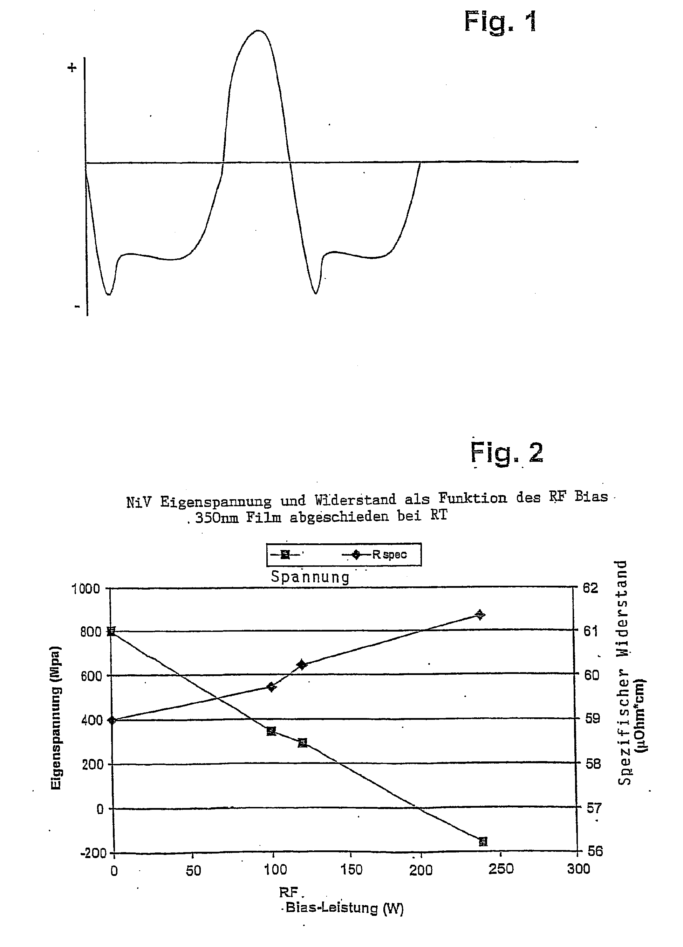

Bei dem vorliegenden Vergleichsbeispiel wird die Beeinflussung der Eigenspannungen in NiV-Schichten durch Anlegen einer RF-Bias-Spannung an das Substrat während des Abscheidens mit der Eigenspannungsentwicklung in NiV-Schichten verglichen, die mit unterschiedlichen positiven Spannungspulsen nach dem erfindungsgemäßen Verfahren abgeschieden worden sind. Fig. 1 zeigt die typische Signalform, die bei dem erfindungsgemäßen Verfahren verwendet wird. Neben einer Halbwelle mit negativem Potential tritt hier in jedem Zyklus eine Halbwelle mit positivem Potential am Target auf

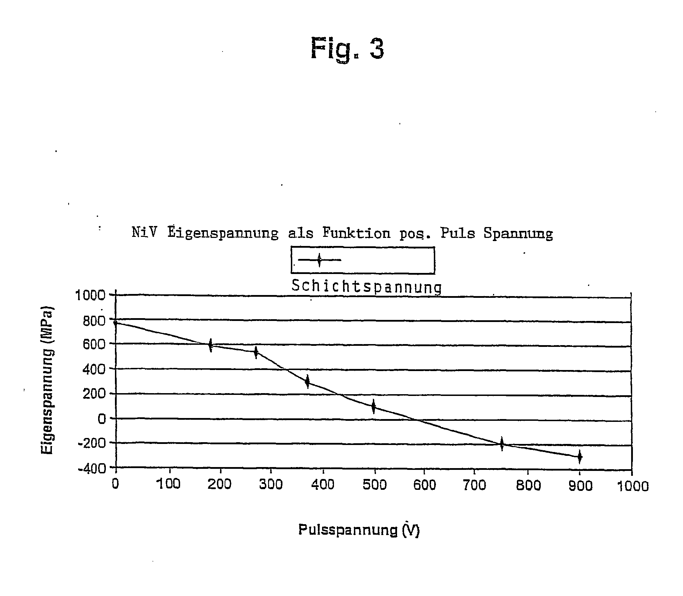

Beim Vergleich der Eigenspannungen innerhalb der NiV-Schichten, die einerseits mit einem Verfahren nach dem Stand der Technik (Fig. 2) und nach dem erfindungsgemäßen Verfahren (Fig. 3) abgeschieden worden sind, wird deutlich, dass mit dem erfindungsgemäßen Verfahren dieselben Wirkungen erzielt werden können, wie mit einer Substrat-Bias-Spannung.

Die NiV-Schichten, deren Eigenspannungen über der RF-Leistung in Fig. 2 aufgetragen sind, wurden auf einem geheizten Substrat abgeschieden, an das bipolar gepulste RF-Bias-Spannung angelegt wurde. Es wurden NiV-Schichten mit einer Schichtdicke von ca. 3500 A bei einer Sputterrate von ca. 15,6 A/KW sek. mit einer Sputterleistung von 9 KW bei einem Argonfluss von ca. 48 sccm durch reguläres Gleichspannungs(DC)-Sputtern abgeschieden. Wie in Fig. 2 zu sehen ist, nimmt mit zunehmender RF-Bias-Leistung die Eigenspannung in den NiV-Schichten ab, bis sich sogar statt der Zugeigenspannung eine geringe Druckeigenspannung aufbaut.

Diese positive Wirkung wurde nun bei den NiV-Schichten, die mit dem erfindungsgemäßen Verfahren hergestellt wurden, auch ohne Verwendung einer Bias-Spannung erzeugt, und zwar durch Verwendung des erfindungsgemäßen bipolaren Pulses am Target (vgl. Fig. 1). Im Übrigen blieben die Parameter unverändert. Wie der Fig. 3 zu entnehmen ist wird in den NiV-Schichten mit zunehmend höherem positiven Potential des positiven Spannungspulses eine Erniedrigung der Zugeigenspannungen bewirkt bzw. sogar eine Einstellung einer Druckeigenspannung ermöglicht. Bei einer Abscheidung der NiV-Schichten ohne positiven Pulsanteil wurden hingegen keine signifikanten Eigenspannungsänderungen in den NiV-Schichten auch bei einer Variation der negativen Pulsspannungen von -900V bis ca. -1600V registriert.

## Patentansprüche

1. Verfahren zur Herstellung eigenspannungsoptimierter, insbesondere zugspannungsarmer Beschichtungen mittels Sputterprozessen, bei denen am Target (Kathode) ein bipolar gepulster Spannungsverlauf erzeugt wird, **dadurch gekennzeichnet, dass** der positive Spannungspuls am Target so eingestellt wird, dass Ionen auf das Substrat beschleunigt werden und auf der Beschichtung infolge dieser Beschleunigung auftreffen.

2. Verfahren nach Anspruch 1, **dadurch gekennzeichnet, dass** der positive Spannungspuls durch die Überlagerung einer negativen Signalgrundform mit einem gepulsten positiven Spannungssignal erzeugt wird, wobei das gepulste positive Spannungssignal in Frequenz, Signalform, Amplitude und dgl. einstellbar ist.

3. Verfahren nach Anspruch 1 oder 2, **dadurch gekennzeichnet, dass** der positive Spannungspuls eine Amplitude von 30 bis 2000 V, insbesondere 40 bis 1800 V, vorzugsweise 50 bis 1000 V aufweist.

4. Verfahren nach einem der vorhergehenden Ansprüche, **dadurch gekennzeichnet, dass** der positive Spannungspuls eine Pulsdauer von 1 bis 20 µs aufweist.

5. Verfahren nach einem der vorhergehenden Ansprüche, **dadurch gekennzeichnet, dass** der positive Spannungspuls mit einer Frequenz von 15 bis 450 kHz angelegt wird.

## Claims

1. A method for producing coatings with optimized internal stress, in particular with low internal tensile stress, through sputtering processes, wherein a bipolar-pulsed voltage curve is generated at a target (cathode), wherein a positive voltage pulse at the target is adjusted, so that ions are accelerated towards a substrate and impact the coating due to the acceleration.

2. The method according to claim, 1 wherein the positive voltage pulse is generated through superimposing a negative basic signal curve with a pulsed positive voltage signal, wherein the pulsed positive pulse voltage signal is adjustable with respect to frequency, signal form, amplitude and similar.

3. The method according to claim 1 or 2, wherein the positive voltage pulse comprises an amplitude of 30 to 2,000 V, in particular 40 to 1,800 V, preferably 50 to 1,000 V.

4. The method according to one of the preceding claims, wherein the positive voltage pulse comprises a pulse duration of 1 to 20 µs.

5. The method according to one of the preceding claims, wherein the positive voltage pulse is applied with a frequency of 15 to 450 kHz.

## Revendications

1. Procédé de fabrication de revêtements optimisés quant aux contraintes internes, en particulier pauvres en contraintes de traction, au moyen de procédés de pulvérisation cathodique au cours desquels on produit, au niveau de la cible (cathode), un profil de tension pulsée bipolaire,
**caractérisé en ce que** l'impulsion de tension positive, au niveau de la cible, est réglée de manière telle que des ions soient accélérés vers le substrat et produisent un impact sur le revêtement, par suite de cette accélération.

2. Procédé selon la revendication 1, **caractérisé en ce que** l'impulsion de tension positive est produite par la superposition d'une forme de base négative d'un signal, avec un signal de tension positif pulsé, le signal de tension positif pulsé étant réglable en fréquence, en forme de signal, en amplitude et autres semblables.

3. Procédé selon la revendication 1 ou 2, **caractérisé en ce que** l'impulsion de tension positive présente une amplitude de 30 à 2000 V, en particulier de 40 à 1800 V, de préférence de 50 à 1000 V.

4. Procédé selon l'une des revendications précédentes, **caractérisé en ce que** l'impulsion de tension positive présente une durée d'impulsion de 1 à 20 µs.

5. Procédé selon l'une des revendications précédentes, **caractérisé en ce que** l'impulsion de tension positive est appliquée à une fréquence de 15 à 450 kHz.
